# EUROPEAN PATENT APPLICATION

(11) **EP 4 687 399 A1**
(43) Date of publication of application: **04.02.2026**
(21) Application number: 25164976.0
(22) Date of filing: 20.03.2025
(51) Int. Cl.: H10D 89/60, H10D 8/80

(54) **ELECTROSTATIC DISCHARGE PROTECTION DEVICE**

(30) Priority: 02.08.2024 KR 20240102959
(71) Applicant: Samsung Electronics Co., Ltd., Suwon-si, Gyeonggi-do 16677 (KR)
(72) Inventor: SONG, Jongkyu, 16677 Suwon-si, Gyeonggi-do (KR); HEO, Jin, 16677 Suwon-si, Gyeonggi-do (KR); KIM, Minho, 16677 Suwon-si, Gyeonggi-do (KR); KIM, Sukjin, 16677 Suwon-si, Gyeonggi-do (KR); JUNG, Jinwoo, 16677 Suwon-si, Gyeonggi-do (KR)
(74) Representative: Kuhnen & Wacker Patent- und Rechtsanwaltsbüro PartG mbB

(57) **Abstract**

An electrostatic discharge protection device includes a substrate (110), a first doping region (131) of a first conductivity type on the substrate (110), a second doping region (132) of the first conductivity type on the substrate (110), an epitaxial layer (121) of a second conductivity type between the first doping region (131) and the second doping region (132), a first diffusion region (181) of the first conductivity type on the first doping region (131), a second diffusion region (182) of the second conductivity type on the epitaxial layer (121) , a third diffusion region (183) of the first conductivity type on the second doping region (132), and a fourth diffusion region (184) of the second conductivity type on the first doping region (131) and spaced apart from the first diffusion region (181). The first diffusion region (181) and the fourth diffusion region (184) are electrically coupled.

## Description

### BACKGROUND

### 1. Field

The present disclosure relates generally to electrostatic discharge protection devices, and more particularly, to an electrostatic discharge protection device for protecting an integrated circuit device from a reverse electrostatic discharge (ESD) voltage.

### 2. Description of the Related Art

Semiconductor devices and/or integrated circuits may be sensitive to electrostatic discharge (ESD) pulses and/or may be particularly susceptible to physical damage by the high voltages and/or currents generated by ESD pulses. As the size of semiconductor devices gradually decreases, the voltage that the semiconductor devices may withstand without damage may also decrease. Consequently, input/output terminals of the semiconductor devices may typically be provided with electrostatic discharge protection devices to protect the semiconductor devices from damage that may be caused by pulses.

An electrostatic discharge protection device may be provided to relatively quickly and/or relatively safely remove and/or reduce an ESD pulse having a relatively high voltage and/or a relatively high current when the ESD pulse is applied to a semiconductor device.

### SUMMARY

One or more example embodiments of the present disclosure provide an electrostatic discharge protection device capable of protecting an integrated circuit device or the like from a reverse electrostatic discharge (ESD) voltage and having a relatively small size, when compared to related electrostatic discharge protection devices, by including a fourth diffusion region electrically connected to a first diffusion region.

According to an aspect of the present disclosure, an electrostatic discharge protection device includes a substrate, a first doping region of a first conductivity type on the substrate, a second doping region of the first conductivity type on the substrate, an epitaxial layer of a second conductivity type between the first doping region and the second doping region, a first diffusion region of the first conductivity type on the first doping region, a second diffusion region of the second conductivity type on the epitaxial layer, a third diffusion region of the first conductivity type on the second doping region, and a fourth diffusion region of the second conductivity type on the first doping region and spaced apart from the first diffusion region. The first diffusion region and the fourth diffusion region are electrically coupled.

According to an aspect of the present disclosure, an electrostatic discharge protection device includes a substrate, a first doping region of a first conductivity type on the substrate, a second doping region of the first conductivity type on the substrate and spaced apart from the first doping region, an epitaxial layer of a second conductivity type between the first doping region and the second doping region, a first well region of the second conductivity type on the first doping region, a second well region of the first conductivity type on the first doping region and spaced apart from the first well region, a third well region of the second conductivity type on the epitaxial layer, a first diffusion region of the first conductivity type on the second well region, a second diffusion region of the second conductivity type on the third well region, a third diffusion region of the first conductivity type on the second doping region, and a fourth diffusion region on the first well region. The first diffusion region and the fourth diffusion region are electrically coupled. A first doping concentration of the third well region is greater than a second doping concentration of the epitaxial layer.

According to an aspect of the present disclosure, an electrostatic discharge protection device includes a substrate, a first doping region of a first conductivity type on the substrate, a second doping region of the first conductivity type on the substrate and spaced apart from the first doping region, an epitaxial layer of a second conductivity type between the first doping region and the second doping region, a first well region of the second conductivity type on the first doping region, a second well region of the first conductivity type on the first doping region and spaced apart from the first well region, a first drift region of the second conductivity type on the epitaxial layer, a third well region of the second conductivity type on the first drift region and forming a junction interface with the second well region, a first diffusion region of the first conductivity type on the second well region, a second diffusion region of the second conductivity type on the third well region, a third diffusion region of the first conductivity type on the second doping region, and a fourth diffusion region of the second conductivity type on the first well region. The first diffusion region and the fourth diffusion region are electrically coupled. A first doping concentration of the first drift region is less than a second doping concentration of the third well region. The first doping concentration of the first drift region is larger than a third doping concentration of the epitaxial layer. A fourth doping concentration of the first well region is greater than the third doping concentration of the epitaxial layer.

According to embodiments, the electrostatic discharge protection device may protect integrated circuit devices and the like from reverse ESD voltages and may have a small size.

Additional aspects may be set forth in part in the description which follows and, in part, may be apparent from the description, and/or may be learned by practice of the presented embodiments.

### BRIEF DESCRIPTION OF THE DRAWINGS

The above and other aspects, features, and advantages of certain embodiments of the present disclosure may be more apparent from the following description taken in conjunction with the accompanying drawings, in which:
FIG. 1 is a schematic circuit diagram showing a semiconductor device including a general electrostatic discharge protection device, according to an embodiment;
FIG. 2 is a top plan view showing an electrostatic discharge protection device, according to an embodiment;
FIG. 3 is a cross-sectional view taken along line A-A' of FIG. 2, according to an embodiment;
FIG. 4 is an enlarged cross-sectional view of region R1 of FIG. 3, according to an embodiment;
FIG. 5 is an equivalent circuit diagram of an electrostatic discharge protection device, according to an embodiment;
FIG. 6 is a graph showing a voltage-current curve of an electrostatic discharge protection device, according to an embodiment;
FIGS. 7 to 13 are cross-sectional views corresponding to line A-A' of FIG. 2, illustrating electrostatic discharge protection devices, according to some embodiments; and
FIG. 14 is a block diagram illustrating a system including an electrostatic discharge protection device, according to an embodiment.

### DETAILED DESCRIPTION

The present disclosure is described hereinafter with reference to the accompanying drawings, in which embodiments of the present disclosure are shown. As those skilled in the art may recognize, the described embodiments may be modified in various different ways, all without departing from the scope of the present disclosure.

The drawings and description are to be regarded as illustrative in nature and not restrictive, and like reference numerals may designate like elements throughout the specification.

Size and thickness of each constituent element in the drawings may be arbitrarily illustrated for better understanding and ease of description, but the following embodiments are not limited thereto. In the drawings, the thicknesses of layers and regions may be exaggerated for clarity. In the drawings, the thickness of some layers and regions may be exaggerated for ease of description.

It is to be understood that when an element such as a layer, film, region, or substrate is referred to as being "on" another element, the element may be directly on the other element or intervening elements may also be present. In contrast, when an element is referred to as being "directly on" another element, there are no intervening elements present. Further, when an element is referred to as being "on" or "above" a reference element, the element may be disposed above or below the reference element, and the element may not necessarily be referred to as being disposed "on" or "above" the reference element in a direction opposite to gravity.

In addition, unless explicitly stated to the contrary, the word "comprise," and variations such as, but not limited to, "comprises" and "comprising" may be understood to imply the inclusion of stated elements but not the exclusion of any other elements.

In addition, the phrase "on a plane" may refer to a view from a position above the object (e.g., from the top), and the phrase "in a cross-section" may refer to a view of a cross-section of the object which may be vertically cut from the side.

As used herein, when an element or layer is referred to as "covering", "overlapping", or "surrounding" another element or layer, the element or layer may cover at least a portion of the other element or layer, where the portion may include a fraction of the other element or may include an entirety of the other element. Similarly, when an element or layer is referred to as "penetrating" another element or layer, the element or layer may penetrate at least a portion of the other element or layer, where the portion may include a fraction of the other element or may include an entire dimension (e.g., length, width, depth) of the other element.

Reference throughout the present disclosure to "one embodiment," "an embodiment," "an example embodiment," or similar language may indicate that a particular feature, structure, or characteristic described in connection with the indicated embodiment is included in at least one embodiment of the present solution. Thus, the phrases "in one embodiment", "in an embodiment," "in an example embodiment," and similar language throughout this disclosure may, but do not necessarily, all refer to the same embodiment. The embodiments described herein are example embodiments, and thus, the disclosure is not limited thereto and may be realized in various other forms.

The embodiments herein may be described and illustrated in terms of blocks, as shown in the drawings, which carry out a described function or functions. These blocks, which may be referred to herein as units or modules or the like, or by names such as device, logic, circuit, controller, counter, comparator, generator, converter, or the like, may be physically implemented by analog and/or digital circuits including one or more of a logic gate, an integrated circuit, a microprocessor, a microcontroller, a memory circuit, a passive electronic component, an active electronic component, an optical component, and the like.

In the present disclosure, the articles "a" and "an" are intended to include one or more items, and may be used interchangeably with "one or more." Where only one item is intended, the term "one" or similar language is used. For example, the term "a processor" may refer to either a single processor or multiple processors. When a processor is described as carrying out an operation and the processor is referred to perform an additional operation, the multiple operations may be executed by either a single processor or any one or a combination of multiple processors.

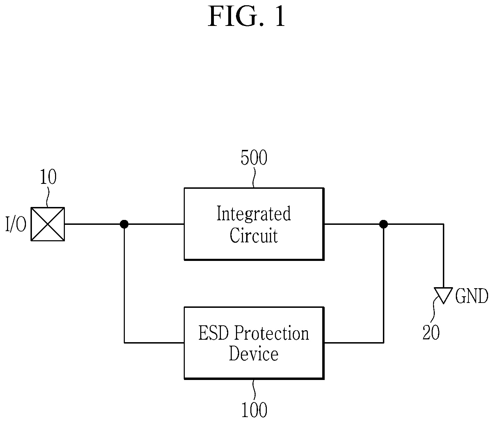

Hereinafter, an electrostatic discharge protection device according to an embodiment is described with reference to FIG. 1.

FIG. 1 is a schematic circuit diagram showing a semiconductor device including a general electrostatic discharge (ESD) protection device, according to an embodiment.

Referring to FIG. 1, an electrostatic discharge protection device 100 may be disposed between an input/output (I/O) terminal 10 and a ground terminal 20 to which a ground voltage is applied. An integrated circuit device 500 may be protected from unwanted electrostatic discharge pulses by the electrostatic discharge protection device 100.

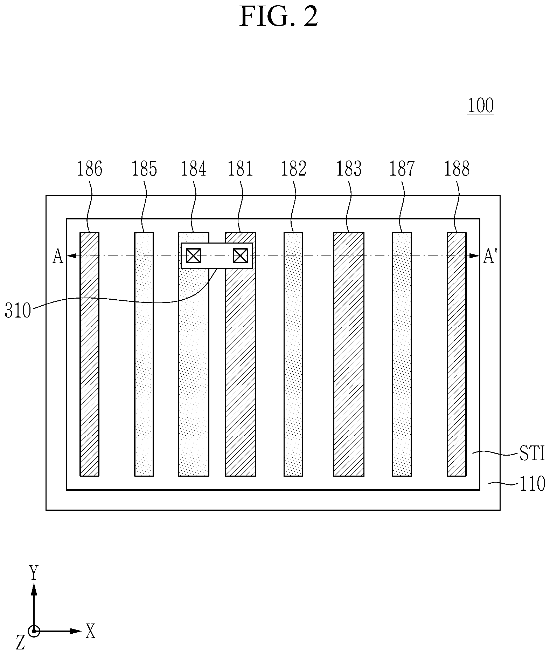

For example, the electrostatic discharge protection device 100 may protect the integrated circuit device 500 connected to the I/O terminal 10 and the ground terminal 20 from the electrostatic discharge pulse. For example, a voltage higher or lower than the potential of the ground terminal 20 may be applied to the I/O terminal 10, and the resulting electrostatic pulse may be discharged by the electrostatic discharge protection device 100. The integrated circuit device 500 may include various devices including electrical elements. Electrostatic discharge protection devices 100 that may be employed herein are illustrated and described with reference to FIGS. 2 to 13.

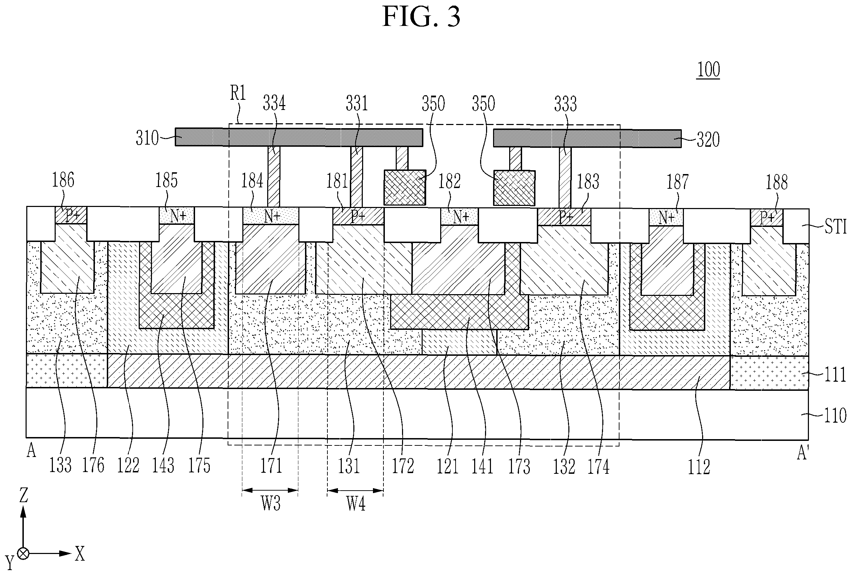

Hereinafter, an electrostatic discharge protection device according to an embodiment is described with reference to FIGS. 2 and 3.

FIG. 2 is a top plan view showing an electrostatic discharge protection device, according to an embodiment. FIG. 3 is a cross-sectional view taken along line A-A' of FIG. 2, according to an embodiment.

First, referring to FIGS. 2 and 3, the electrostatic discharge (ESD) protection device 100, according to an embodiment, may include a substrate 110, a first doping region 131 and a second doping region 132 disposed on the substrate 110, a first epitaxial layer 121 disposed between the first doping region 131 and the second doping region 132, a first diffusion region 181 disposed on the first doping region 131, a second diffusion region 182 disposed on the first epitaxial layer 121, a third diffusion region 183 disposed on the second doping region 132, and a fourth diffusion region 184 disposed on the first doping region 131 and electrically connected to the first diffusion region 181.

The substrate 110 may be, for example, a silicon (Si) substrate, a germanium (Ge) substrate, or a silicon-germanium (Si-Ge) substrate. In an embodiment, the substrate 110 may be a substrate of a first conductivity type. For example, the first conductivity type may be p-type. However, the present disclosure is not limited thereto, and the substrate 110 may be a substrate of a second conductive substrate different from the first conductivity type. For example, the second conductivity type may be n-type.

The electrostatic discharge protection device 100, according to an embodiment, may further include embedded layers (e.g., a first embedded layers 111 and a second embedded layer 112) disposed on the substrate 110.

The first and second embedded layers 111 and 112 may be disposed on the upper surface of the substrate 110. In an embodiment, the first and second embedded layers 111 and 112 may include the first embedded layers 111 and the second embedded layer 112 having different conductivity types. The first embedded layers 111 and the second embedded layer 112 may extend in a second direction (Y direction), however, the present disclosure is not limited thereto. The second embedded layer 112 may be disposed between the first embedded layers 111. The second embedded layer 112 may be disposed on one side of the first embedded layers 111, however the present disclosure is not limited thereto, and the second embedded layer 112 may be surrounded by the first embedded layers 111.

The first embedded layers 111 and the second embedded layer 112 may include silicon (Si). The first embedded layers 111 may have a highly doped first conductive region. For example, the first embedded layers 111 may be a p++ type and may have a higher impurity concentration than other doping regions. The doping concentration of the first embedded layers 111 may be greater than the doping concentration of the substrate 110. The second embedded layer 112 may have a highly doped second conductive region. For example, the second embedded layer 112 may be an N++ type and may have a higher impurity concentration than the other doping regions. The doping concentration of the second embedded layer 112 may be greater than the doping concentration of the substrate 110.

Doping regions may be disposed on the first and second embedded layers 111 and 112. For example, the electrostatic discharge protection device 100, according to an embodiment, may include the first doping region 131 and the second doping region 132, which may be disposed on the second embedded layer 112.

The first doping region 131 and the second doping region 132 may be disposed on the substrate 110. The first doping region 131 and the second doping region 132 may be disposed on the upper surface of the second embedded layer 112 on the substrate 110. The first doping region 131 and the second doping region 132 may extend in the second direction (Y direction) and may be spaced apart from each other in a first direction (X direction). The first doping region 131 and the second doping region 132 may contain a substantially similar and/or the same material. The first doping region 131 and the second doping region 132 may be of the same conductivity type. For example, the first doping region 131 and the second doping region 132 may be doped with first conductivity type impurities to have the first conductivity type. For example, the first conductivity type may be p-type. The doping concentrations of the first doping region 131 and the second doping region 132 may be smaller than the doping concentration of the second embedded layer 112. In an embodiment, the first doping region 131 and the second doping region 132 may be high-voltage p-well (HVPW) regions.

The electrostatic discharge protection device 100, according to an embodiment, may further include a third doping region 133 disposed on the first embedded layers 111.

The third doping region 133 may extend in the second direction (Y direction) and may be spaced apart from the first doping region 131 and the second doping region 132 in the first direction (X direction). The first doping region 131 and the second doping region 132 may be spaced apart from each other by a predetermined interval. The third doping region 133 may include a substantially similar and/or the same material as the first doping region 131 and the second doping region 132, and the third doping region 133 may be of the same conductivity type as the first doping region 131 and the second doping region 132. For example, the third doping region 133 may be doped with the first conductivity type impurity to be the first conductivity type. In this case, the doping concentration of the third doping region 133 may be substantially similar and/or the same as the doping concentration of the first doping region 131 and the doping concentration of the second doping region 132, however, the present disclosure is not limited thereto.

The epitaxial layers (e.g., first epitaxial layers 121 and second epitaxial layers 122) may be disposed on the substrate 110. The first and second epitaxial layers 121 and 122 may be disposed on the upper surface of the second embedded layer 112 on the substrate 110. For example, the first and second epitaxial layers 121 and 122 may include the first epitaxial layer 121 disposed between the first doping region 131 and the second doping region 132 on the second embedded layer 112. As used herein, the first epitaxial layer 121 may refer to an epitaxial layer disposed between the first doping region 131 and the second doping region 132.

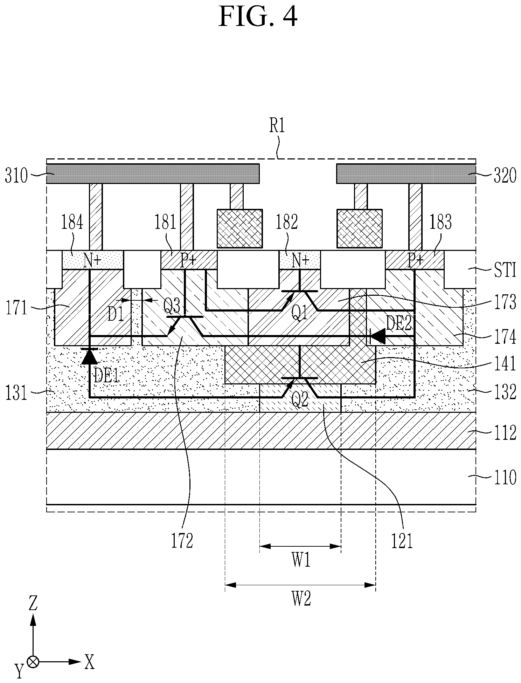

The first epitaxial layer 121 may be disposed between the first doping region 131 and the second doping region 132. The first epitaxial layer 121 may extend in the second direction (Y direction), however, the present disclosure is not limited thereto. The first epitaxial layer 121 may be in contact with the first doping region 131 and the second doping region 132. For example, the side surface of the first epitaxial layer 121 may form a junction interface with the side surface of the first doping region 131 and the side surface of the second doping region 132. The first epitaxial layer 121 may have a predetermined width. For example, the first epitaxial layer 121 may have a first width (W1 in FIG. 4) extending in the first direction (X direction). The size of the trigger voltage of the electrostatic discharge protection device 100 may be determined according to the first width (W1 in FIG. 4) in the first direction (X direction) of the first epitaxial layer 121. A description thereof is provided with reference to FIGS. 4 to 6.

The first epitaxial layer 121 may be disposed in the same layer as the first doping region 131 and the second doping region 132. For example, the lower surface of the first epitaxial layer 121 may be disposed at a substantially similar and/or the same level as the lower surface of the first doping region 131 and the lower surface of the second doping region 132. That is, the lower surface of the first epitaxial layer 121 may be disposed at a substantially similar and/or the same distance from the lower surface of the first doping region 131 and the lower surface of the second doping region 132 and the upper surface of the substrate 110.

The first epitaxial layer 121 may include a substantially similar and/or the same material as the substrate 110 and/or the second embedded layer 112. For example, the first epitaxial layer 121 may include silicon (Si), however, the present disclosure is not limited thereto. The first epitaxial layer 121 may be doped with the second conductive impurity to have the second conductivity type. The second conductivity type may be n-type. At this time, the doping concentration of the first epitaxial layer 121 may be less than the doping concentration of the second embedded layer 112. Accordingly, when a depletion region is formed by a reverse bias state between the first doping region 131 having the first conductivity type and the first epitaxial layer 121 having the second conductivity type, a punch-through phenomenon in which the depletion region is formed up to the second doping region 132 may occur.

In an embodiment, the first and second epitaxial layers 121 and 122 may further include the second epitaxial layer 122 disposed between the first doping region 131 and the third doping region 133 and between the second doping region 132 and the third doping region 133. As used herein, the second epitaxial layer 122 may refer to as an epitaxial layer disposed on the outer side of the first doping region 131 and the outer side of the second doping region 132, respectively. The second epitaxial layer 122 may include a substantially similar and/or the same material as the first epitaxial layer 121. The second epitaxial layer 122 may have the same conductivity type as the first epitaxial layer 121. For example, the second epitaxial layer 122 may be doped with the second conductive impurity to have the second conductivity type. The second conductivity type may be an n-type. In this case, the doping concentration of the second epitaxial layer 122 may be less than the doping concentration of the second embedded layer 112.

In an embodiment, diffusion regions (e.g., a first diffusion region 181, a second diffusion region 182, a third diffusion region 183, a fourth diffusion region 184, a fifth diffusion region 185, a sixth diffusion region 186, a seventh diffusion region 187, and an eighth diffusion region 188) may be disposed on the substrate 110. The first to eighth diffusion regions 181 to 188 may be disposed on the first and second embedded layers 111 and 112 on the substrate 110. The first to eighth diffusion regions 181 to 188 may be disposed directly on the upper surfaces of well regions (e.g., a first well region 171, a second well region 172, a third well region 173, a fourth well region 174, a fifth well region 175, and a sixth well region 176), however, the present disclosure is not limited thereto. In an embodiment, the first to eighth diffusion regions 181 to 188 may extend in the second direction (Y direction) and/or may be spaced apart from each other in the first direction (X direction). The first to eighth diffusion regions 181 to 188 may be separated from each other by an isolation layer STI, and may be electrically blocked from each other. The first to eighth diffusion regions 181 to 188 may be provided as contact regions.

For example, the electrostatic discharge protection device 100, according to an embodiment, may include the first to fourth diffusion regions 181 to 184.

The first diffusion region 181 may be disposed on the first doping region 131. The first diffusion region 181 may extend in the second direction (Y direction). The first diffusion region 181 may be doped with the first conductivity type impurity to have the first conductivity type. The first conductivity type may be a p-type. For example, the first diffusion region 181 may have a p+ type and may have a higher impurity concentration than a third well region 173. The doping concentration of the first diffusion region 181 may be greater than the doping concentration of the first doping region 131. In an embodiment, the first diffusion region 181 may configure an emitter node of a first transistor (e.g., first transistor Q1 of FIG. 4) and an emitter node of a third transistor (e.g., third transistor Q3 of FIG. 4) of the electrostatic discharge protection device 100, according to an embodiment.

The second diffusion region 182 may be disposed on the first epitaxial layer 121. The second diffusion region 182 may extend in the second direction (Y direction) and may be spaced apart from the first diffusion region 181 in the first direction (X direction). The second diffusion region 182 may be doped with the second conductive impurity to have the second conductivity type. The second conductivity type may be an n-type. For example, the second diffusion region 182 may have an n+ type and may have a higher impurity concentration than the third well region 173. The doping concentration of the second diffusion region 182 may be greater than the doping concentration of the first epitaxial layer 121. In an embodiment, the second diffusion region 182 may configure a base node of the first transistor (e.g., first transistor Q1 of FIG. 4), a base node of a second transistor (e.g., second transistor Q2 of FIG. 4), and a collector node of a third transistor (e.g., third transistor Q3 of FIG. 4) of the electrostatic discharge protection device 100.

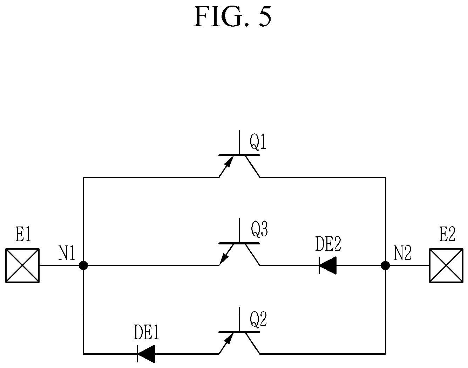

The third diffusion region 183 may be disposed on the second doping region 132. The third diffusion region 183 may extend in the second direction (Y direction) and may be spaced apart from the first diffusion region 181 and the second diffusion region 182 in the first direction (X direction). In an embodiment, the third diffusion region 183 may configure a collector node of the first transistor (e.g., first transistor Q1 of FIG. 4) and a collector node of the second transistor (e.g., second transistor Q2 of FIG. 4) of the electrostatic discharge protection device 100 according to an embodiment. In an embodiment, the third diffusion region 183 may be electrically connected to a second connection wiring 320 via a third via 333. The second connection wiring 320 may be connected to a second electrode (e.g., second electrode E2 in FIG. 5), and the second electrode (e.g., second electrode E2 in FIG. 5) may be a cathode electrode connected to a ground node.

The third diffusion region 183 may be doped with the first conductivity type impurity to have the first conductivity type. The first conductivity type may be a p-type. For example, the third diffusion region 183 may have a p+ type and may have a higher impurity concentration than the fourth well region 174. The doping concentration of the third diffusion region 183 may be greater than the doping concentration of the second doping region 132.

The fourth diffusion region 184 may be disposed on the first doping region 131. The fourth diffusion region 184 may extend in the second direction (Y direction) and may be spaced apart from the first diffusion region 181 to the third diffusion region 183 in the first direction (X direction). In an embodiment, the fourth diffusion region 184 may be disposed on one side of the first diffusion region 181. That is, the first diffusion region 181 may be disposed between the fourth diffusion region 184 and the second diffusion region 182.

The fourth diffusion region 184 may be doped with the second conductive impurity to have the second conductivity type. The second conductivity type may be an n-type. For example, the fourth diffusion region 184 may have an n+ type and may have a higher impurity concentration than the first well region 171. The doping concentration of the fourth diffusion region 184 may be greater than the doping concentration of the first epitaxial layer 121.

In an embodiment, the fourth diffusion region 184 may configure an electrode of a first diode (e.g., first diode DE1 of FIG. 4) and an emitter node of a third transistor (e.g., third transistor Q3 of FIG. 4) of the electrostatic discharge protection device 100. In an embodiment, the fourth diffusion region 184 and the first diffusion region 181 may be electrically connected. For example, the fourth diffusion region 184 and the first diffusion region 181 may be electrically connected to each other through a first connection wiring 310, a first via 331 connecting the fourth diffusion region 184 and the first connection wiring 310, and a second via 334 connecting the first diffusion region 181 and the first connection wiring 310. The first connection wiring 310, the first via 331, and the second via 334 may include a conductive material. For example, the first connection wiring 310 may be connected to the first electrode (e.g., first electrode E1 of FIG. 5), and the first electrode may be an anode electrode that may receive an electrostatic discharge voltage.

In an embodiment, a third width W3 of the fourth diffusion region 184 in the first direction (X direction) may be greater than a fourth width W4 of the first diffusion region 181 in the first direction (X direction), however, the present disclosure is not limited thereto. In the above range, the contact resistance between the first connection wiring 310 and the fourth diffusion region 184 may be reduced.

The electrostatic discharge protection device 100, according to an embodiment, may further include fifth to eighth diffusion regions 185 to 188.

The fifth diffusion region 185 and the seventh diffusion region 187 may be disposed on the second epitaxial layer 122. The fifth diffusion region 185 may be disposed on one side of the fourth diffusion region 184, and the seventh diffusion region 187 may be disposed on one side of the third diffusion region 183. That is, the fourth diffusion region 184 may be disposed between the fifth diffusion region 185 and the first diffusion region 181, and the third diffusion region 183 may be disposed between the second diffusion region 182 and the seventh diffusion region 187. The fifth diffusion region 185 and the seventh diffusion region 187 may be doped with the second conductive impurities to have the second conductivity type. The second conductivity type may be an n-type. For example, the fifth diffusion region 185 and the seventh diffusion region 187 may have an n+ type and may have a higher impurity concentration than a fifth well region 175. The doping concentration of the fifth diffusion region 185 and the doping concentration of the seventh diffusion region 187 may be higher than the doping concentration of the second epitaxial layer 122.

The sixth diffusion region 186 and the eighth diffusion region 188 may be disposed on the third doping region 133. The sixth diffusion region 186 may be disposed on one side of the fifth diffusion region 185, and the eighth diffusion region 188 may be disposed on one side of the seventh diffusion region 187. That is, the fifth diffusion region 185 may be disposed between the sixth diffusion region 186 and the fourth diffusion region 184, and the seventh diffusion region 187 may be disposed between the third diffusion region 183 and the eighth diffusion region 188. The sixth diffusion region 186 and the eighth diffusion region 188 may be doped with the first conductivity type impurities to have the first conductivity type.

The first conductivity type may be a p-type. For example, the sixth diffusion region 186 and the eighth diffusion region 188 may have a p+ type and may have a higher impurity concentration than the third doping region 133.

The electrostatic discharge protection device 100, according to an embodiment, may further include the isolation layer STI disposed between the first to eighth diffusion regions 181 to 188.

The isolation layer STI may be disposed between the first to eighth diffusion regions 181 to 188. For example, the isolation layer STI may be disposed between the fourth diffusion region 184 and the first diffusion region 181, between the first diffusion region 181 and the second diffusion region 182, and between the second diffusion region 182 and the third diffusion region 183. Additionally, the isolation layer STI may be disposed between the fourth diffusion region 184 and the fifth diffusion region 185, between the fifth diffusion region 185 and the sixth diffusion region 186, between the third diffusion region 183 and the seventh diffusion region 187, and between the seventh diffusion region 187 and the eighth diffusion region 188. In an embodiment, the isolation layer STI may surround each of the diffusion regions 181 to 188. The first to eighth diffusion regions 181 to 188 may be separated from each other by the isolation layer STI. Each of the first to eighth diffusion regions 181 to 188 may be electrically isolated from each other by the isolation layer STI. The isolation layer STI may be, but is not limited to, a field oxide layer or a shallow trench isolation (STI). For example, the isolation layer STI may include, but is not limited to, silicon oxide (SiO).

The electrostatic discharge protection device 100, according to an embodiment, may include first to sixth well regions 171 to 176 disposed between the first and second epitaxial layers 121 and 122 and the first to eighth diffusion regions 181 to 188 or between first to third doping regions 131 to 133 and the first to eighth diffusion regions 181 to 188.

For example, the electrostatic discharge protection device 100, according to an embodiment, may include the first well region 171 disposed between the first doping region 131 and the fourth diffusion region 184, a second well region 172 disposed between the first doping region 131 and the first diffusion region 181, the third well region 173 disposed between the first epitaxial layer 121 and the second diffusion region 182, and the fourth well region 174 disposed between the second doping region 132 and the third diffusion region 183.

The first well region 171 may be disposed under the fourth diffusion region 184. For example, the first well region 171 may be disposed directly under the lower surface of the fourth diffusion region 184. The first well region 171 may be in contact with the lower surface of the fourth diffusion region 184, however, the present disclosure is not limited thereto. The first well region 171 may be disposed in the first doping region 131. The first well region 171 may be surrounded by the first doping region 131. The lower surface and side surface of the first well region 171 may be in contact with the first doping region 131. The lower surface of the first well region 171 may be disposed at a higher level than the lower surface of the first doping region 131. That is, the lower surface of the first well region 171 may be disposed further from the upper surface of the substrate 110 than the lower surface of the first doping region 131. The first well region 171 may overlap the fourth diffusion region 184 and the isolation layer STI disposed on both sides of the fourth diffusion region 184 in the first direction (X direction) in the third direction (Z direction). The width of the first well region 171 in the first direction (X direction) may be greater than the width of the fourth diffusion region 184 in the first direction (X direction), however, the present disclosure is not limited thereto.

In an embodiment, the first well region 171 may have a different conductivity type than the first doping region 131. For example, the first well region 171 may be doped with the second conductive impurity to have the second conductivity type, and the first doping region 131 may be doped with the first conductive impurity to have the first conductivity type. For example, the first conductivity type may be a p-type and the second conductivity type may be an n-type. Accordingly, a PN junction may be formed at the junction interface of the first well region 171 and the first doping region 131, and thus may function as the first diode (e.g., first diode DE1 of FIG. 4) of the electrostatic discharge protection device 100, according to an embodiment. A description thereof is provided with reference to FIGS. 4 and 5. The doping concentration of the first well region 171 may be higher than the doping concentration of the second epitaxial layer 122. The doping concentration of the first well region 171 may be lower than the doping concentration of the fourth diffusion region 184.

The second well region 172 may be disposed under the first diffusion region 181. For example, the second well region 172 may be disposed directly under the lower surface of the first diffusion region 181. The second well region 172 may be in contact with the lower surface of the first diffusion region 181, however, the present disclosure is not limited thereto. The second well region 172 may be disposed on the first doping region 131. At least a part of the second well region 172 may be surrounded by the first doping region 131. Additionally, the second well region 172 may be disposed on a first drift region 141. That is, at least a part of the second well region 172 may be disposed on the first doping region 131, and the remaining part of the second well region 172 may be disposed on the first drift region 141. However, the present disclosure is not limited thereto, and the second well region 172 may not be disposed on the first drift region 141 and may be surrounded by the first doping region 131. The lower surface of the second well region 172 may be in contact with the first doping region 131 and the first drift region 141. The lower surface of the second well region 172 may be disposed at a higher level than the lower surface of the first doping region 131. That is, the lower surface of the second well region 172 may be disposed further from the upper surface of the substrate 110 than the lower surface of the first doping region 131. The lower surface of the second well region 172 may be disposed at a substantially similar and/or the same level as the lower surface of the first well region 171, however, the present disclosure is not limited thereto.

The second well region 172 may overlap the first diffusion region 181 and the isolation layer STI disposed on both sides of the first diffusion region 181 in the first direction (X direction) in the third direction (Z direction). The width of the second well region 172 in the first direction (X direction) may be greater than the width of the second diffusion region 182 in the first direction (X direction), however, the present disclosure is not limited thereto.

In an embodiment, the second well region 172 may be spaced apart from the first well region 171. The first doping region 131 may be disposed between the second well region 172 and the first well region 171. That is, the second well region 172 and the first well region 171 may overlap the first doping region 131 in a horizontal direction (e.g., the first direction (X direction) and/or the second direction (Y direction)). The side surface of the second well region 172 and the side surface of the first well region 171 may be in contact with the first doping region 131, however, the present disclosure is not limited thereto.

In an embodiment, the second well region 172 may have a different conductivity type than the first well region 171. The second well region 172 may have the same conductivity type as the first diffusion region 181. For example, the second well region 172 may be doped with the first conductive impurity to have the first conductivity type, and the first well region 171 may be doped with the second conductive impurity to have the second conductivity type. For example, the first conductivity type may be a p-type and the second conductivity type may be an n-type. The doping concentration of the second well region 172 may be higher than the doping concentration of the first doping region 131 and the doping concentration of the second doping region 132. The doping concentration of the second well region 172 may be lower than the doping concentration of the first diffusion region 181.

The third well region 173 may be disposed under the second diffusion region 182. For example, the third well region 173 may be disposed directly under the lower surface of the second diffusion region 182. The third well region 173 may be in contact with the lower surface of the second diffusion region 182, however, the present disclosure is not limited thereto. The third well region 173 may be disposed on the first epitaxial layer 121. For example, the third well region 173 may be disposed on the first drift region 141 which is disposed on the first epitaxial layer 121. The third well region 173 may be spaced apart from the first epitaxial layer 121 in the third direction (Z direction), however, the present disclosure is not limited thereto. The third well region 173 may overlap the second diffusion region 182 and the isolation layer STI disposed on both sides of the second diffusion region 182 in the first direction (X direction) in the third direction (Z direction). The width of the third well region 173 in the first direction (X direction) may be greater than the width of the second diffusion region 182 in the first direction (X direction), however, the present disclosure is not limited thereto.

In an embodiment, a side surface of the third well region 173 may be in contact with the side surface of the second well region 172. Accordingly, a PN junction may be formed at the junction interface between the third well region 173 and the second well region 172. Accordingly, the trigger voltage of the first transistor (e.g., first transistor Q1 of FIG. 4) of the electrostatic discharge protection device 100 according to an embodiment may be reduced. A detailed description thereof is provided with reference to FIGS. 4 to 6. However, the present disclosure is not limited thereto, and the side surface of the third well region 173 may be spaced apart from the side surface of the second well region 172 in the second direction (Y direction). The third well region 173 may have the same conductivity type as the second diffusion region 182. For example, the third well region 173 may be doped with the second conductive impurity to have the second conductivity type. The second conductivity type may be an n-type. The doping concentration of the third well region 173 may be greater than the doping concentration of the first epitaxial layer 121. The doping concentration of the third well region 173 may be less than the doping concentration of the second diffusion region 182. Additionally, the doping concentration of the third well region 173 may be greater than the doping concentration of the first drift region 141.

The fourth well region 174 may be disposed under the third diffusion region 183. For example, the fourth well region 174 may be disposed directly under the lower surface of the third diffusion region 183. The fourth well region 174 may be in contact with the lower surface of the third diffusion region 183, however, the present disclosure is not limited thereto. The fourth well region 174 may be disposed on the second doping region 132. At least a part of the fourth well region 174 may be surrounded by the second doping region 132. Additionally, the fourth well region 174 may be disposed on the first drift region 141. That is, at least a part of the fourth well region 174 may be disposed on the second doping region 132, and the remaining part of the fourth well region 174 may be disposed on the first drift region 141. However, the present disclosure is not limited thereto, and the fourth well region 174 may not be disposed on the first drift region 141 and may be surrounded by the second doping region 132. The lower surface of the fourth well region 174 may be in contact with the second doping region 132 and the first drift region 141. The lower surface of the fourth well region 174 may be disposed at a higher level than the lower surface of the second doping region 132. That is, the lower surface of the fourth well region 174 may be disposed further from the upper surface of the substrate 110 than the lower surface of the second doping region 132. The lower surface of the fourth well region 174 may be disposed at a substantially similar and/or the same level as the lower surfaces of the first well region 171 to the third well region 173, however, the present disclosure is not limited thereto.

The fourth well region 174 may overlap the third diffusion region 183 and the isolation layer STI disposed on both sides of the third diffusion region 183 in the first direction (X direction) in the third direction (Z direction). The width of the fourth well region 174 in the first direction (X direction) may be greater than the width of the third diffusion region 183 in the first direction (X direction), however, the present disclosure is not limited thereto.

The fourth well region 174 may have the same conductivity type as the third diffusion region 183. For example, the fourth well region 174 may be doped with the first conductivity type impurity to have the first conductivity type. The first conductivity type may be a p-type. The doping concentration of the fourth well region 174 may be greater than the doping concentrations of the first doping region 131 and the second doping region 132. The doping concentration of the fourth well region 174 may be less than the doping concentration of the third diffusion region 183.

The electrostatic discharge protection device 100, according to an embodiment, may further include the fifth well region 175 and the sixth well region 176.

The fifth well region 175 may be disposed between the fifth diffusion region 185 and the second epitaxial layer 122. The fifth well region 175 may be disposed under the fifth diffusion region 185. For example, the fifth well region 175 may be disposed directly under the lower surface of the fifth diffusion region 185. The fifth well region 175 may be in contact with the lower surface of the fifth diffusion region 185, however, the present disclosure is not limited thereto. The fifth well region 175 may be disposed on the second epitaxial layer 122. For example, the fifth well region 175 may be disposed on a third drift region 143 which is disposed on the second epitaxial layer 122. The fifth well region 175 may be spaced apart from the second epitaxial layer 122 in the third direction (Z direction), however, the present disclosure is not limited thereto.

The fifth well region 175 may have the same conductivity type as the fifth diffusion region 185. For example, the fifth well region 175 may be doped with the second conductive impurity to have the second conductivity type. The second conductivity type may be an n-type. The doping concentration of the fifth well region 175 may be greater than the doping concentration of the second epitaxial layer 122. The doping concentration of the fifth well region 175 may be less than the doping concentration of the fifth diffusion region 185.

The sixth well region 176 may be disposed between the sixth diffusion region 186 and the third doping region 133. The sixth well region 176 may be disposed under the sixth diffusion region 186. For example, the sixth well region 176 may be disposed directly under the lower surface of the sixth diffusion region 186. The sixth well region 176 may be in contact with the lower surface of the sixth diffusion region 186, however, the present disclosure is not limited thereto. The sixth well region 176 may be disposed on the third doping region 133. The sixth well region 176 may be disposed in the third doping region 133. The sixth well region 176 may be surrounded by the third doping region 133. The lower surface and side surface of the sixth well region 176 may be in contact with the third doping region 133, however, the present disclosure is not limited thereto.

The sixth well region 176 may have the same conductivity type as the sixth diffusion region 186. For example, the sixth well region 176 may be doped with the first conductivity type impurity to have the first conductivity type. The first conductivity type may be a p-type. The doping concentration of the sixth well region 176 may be greater than the doping concentration of the third doping region 133. The doping concentration of the sixth well region 176 may be less than the doping concentration of the sixth diffusion region 186.

The electrostatic discharge protection device 100, according to an embodiment, may further include the first drift region 141 disposed between the first epitaxial layer 121 and the third well region 173.

The first drift region 141 may be disposed on the first epitaxial layer 121. For example, the first drift region 141 may be disposed directly on the upper surface of the first epitaxial layer 121, however, the present disclosure is not limited thereto. The first drift region 141 may be disposed between the first epitaxial layer 121 and the third well region 173, between the first epitaxial layer 121 and the first well region 171, and between the first epitaxial layer 121 and the third well region 173. That is, the first drift region 141 may overlap the first well region 171 to the third well region 173 in the third direction (Z direction). The first drift region 141 may be in contact with the first well region 171 to the third well region 173. Additionally, the first drift region 141 may be disposed between the second well region 172 and the third well region 173. In an embodiment, the first drift region 141 may have a predetermined width. For example, the first drift region 141 may have a second width (e.g., second width W2 in FIG. 4) in the first direction (X direction). In an embodiment, the second width of the first drift region 141 in the first direction (X direction) may be greater than or equal to the first width (e.g., first width W1 in FIG. 4) of the first epitaxial layer 121 in the first direction (X direction), however, the present disclosure is not limited thereto. In the above range, the size of a second reverse trigger voltage of the second transistor (e.g., second transistor Q2 in FIG. 4) may be reduced. As used herein, the second reverse trigger voltage may refer to a voltage for the second transistor to be turned on in the reverse direction.

In an embodiment, the first drift region 141 may have the same conductivity type as the first epitaxial layer 121. For example, the first drift region 141 may be doped with the second conductive impurity to have the second conductivity type. The second conductivity type may be an n-type. The doping concentration of the first drift region 141 may be greater than the doping concentration of the first epitaxial layer 121. The doping concentration of the first drift region 141 may be less than the doping concentration of the first well region 171 and the doping concentration of the third well region 173. Accordingly, when a depletion region is formed by a reverse bias state between the first doping region 131 having the first conductivity type and the first drift region 141 having the second conductivity type, a punch-through phenomenon in which the depletion region is formed up to the second doping region 132 may occur.

The electrostatic discharge protection device 100, according to an embodiment, may further include the third drift region 143 disposed between the second epitaxial layer 122 and the fifth well region 175.

The third drift region 143 may be disposed on the second epitaxial layer 122. The third drift region 143 may be surrounded by the second epitaxial layer 122. The third drift region 143 may surround the fifth well region 175. The third drift region 143 may have the same conductivity type as the fifth well region 175 and the second epitaxial layer 122. For example, the third drift region 143 may be doped with the second conductive impurity to have the second conductivity type. The second conductivity type may be n-type. The doping concentration of the third drift region 143 may be greater than the doping concentration of the second epitaxial layer 122 and less than the doping concentration of the fifth well region 175, however, the present disclosure is not limited thereto.

Hereinafter, an electrostatic discharge protection device, according to an embodiment, is described with further reference to FIGS. 4 and 5.

FIG. 4 is an enlarged cross-sectional view of region R1 of FIG. 3. FIG. 5 is an equivalent circuit diagram of an electrostatic discharge protection device according to an embodiment.

Referring further to FIG. 4, the electrostatic discharge protection device 100 according to an embodiment may include a first transistor Q1, a second transistor Q2, a third transistor Q3, a first diode DE1, and a second diode DE2. For example, the first to third transistors Q1 to Q3 may be and/or may include, but are not limited to, bipolar junction transistors (BJTs). For example, the first transistor Q1 and the second transistor Q2 may be PNP bipolar junction transistors, and the third transistor Q3 may be an NPN bipolar junction transistor.

In an embodiment, the first diffusion region 181, the second well region 172, the third well region 173, the first drift region 141, the fourth well region 174, and the third diffusion region 183 may configure the first transistor Q1. For example, the first diffusion region 181 and the second well region 172 may form an emitter of the first transistor Q1, the third well region 173 and the first drift region 141 may form a base of the first transistor Q1, and the fourth well region 174 and the third diffusion region 183 may form a collector of the first transistor Q1.

Additionally, the fourth diffusion region 184, the first well region 171, and the first doping region 131 may form the first diode DE1, and the first doping region 131, the first epitaxial layer 121, the first drift region 141, the second doping region 132, the fourth well region 174, and the third diffusion region 183 may form the second transistor Q2. For example, the first doping region 131 may form an emitter of the second transistor Q2, the first epitaxial layer 121 and the first drift region 141 may form a base of the second transistor Q2, and the second doping region 132, the fourth well region 174, and the third diffusion region 183 may form a collector of the second transistor Q2.

Additionally, the third diffusion region 183, the fourth well region 174, and the first drift region 141 may form the second diode DE2, and the first drift region 141, the third well region 173, the second well region 172, the first doping region 131, the first well region 171, and the fourth diffusion region 184 may form the third transistor Q3. For example, the first drift region 141 and the third well region 173 may form a collector of the third transistor Q3, the second well region 172 and the first doping region 131 may form a base of the third transistor Q3, and the first well region 171 and the fourth diffusion region 184 may form an emitter of the third transistor Q3. In this case, the fourth diffusion region 184 and the first diffusion region 181 may be electrically connected through the first connection wiring 310.

Referring further to FIG. 5, the electrostatic discharge protection device 100, according to an embodiment, may include the first transistor Q1 to the third transistor Q3, the first diode DE1, and the second diode DE2. Additionally, the electrostatic discharge protection device 100, according to an embodiment, may include the first electrode E1 and the second electrode E2. The first electrode E1 may be electrically connected to the first connection wiring 310 of FIG. 4, and the first electrode E1 may be an anode electrode that receives an electrostatic discharge voltage. Additionally, the second electrode E2 may be electrically connected to the second connection wiring 320 of FIG. 4, and the second electrode E2 may be a cathode electrode connected to a ground node.

In an embodiment, the first to third transistors Q1 to Q3 may be electrically connected to the first electrode E1 through a first node N1 and electrically connected to the second electrode E2 through a second node N2. Additionally, the first diode DE1 may electrically connect between the first node N1 and the second transistor Q2, and the second diode DE2 may electrically connect between the third transistor Q3 and the second node N2.

Below, the operation of the electrostatic discharge protection device 100, according to an embodiment, is described.

For better understanding and ease of description, in the following, when the ESD voltage applied to the first electrode E1 has a positive value, the ESD voltage may be referred to as a forward ESD voltage, and when the ESD voltage has a negative value, the ESD voltage may be referred to as a reverse ESD voltage.

In an embodiment, a ground voltage may be applied to the second electrode E2. That is, the forward ESD voltage may be greater than the ground voltage of the second electrode E2, and the reverse ESD voltage may be less than the voltage of the second electrode E2.

Referring to FIGS. 4 and 5, first, when a forward ESD voltage is applied through the first electrode E1, the potential of the first diffusion region 181 and the second well region 172 may rise (increase). Accordingly, the first transistor Q1 including the first diffusion region 181, the second well region 172, the third well region 173, the first drift region 141, the fourth well region 174, and the third diffusion region 183 may be turned on. In this case, the first transistor Q1 may be turned on when the forward ESD voltage is greater than a first forward trigger voltage of the first transistor Q1. As used herein, the first forward trigger voltage may refer to as a voltage for the first transistor Q1 to be turned on in the forward direction. The first forward trigger voltage of the first transistor Q1 may have a predetermined value. For example, the first forward trigger voltage of the first transistor Q1 may be, but is not limited to, 12 Volts (V) to 50 V.

As the first transistor Q1 is turned on, current may flow from the second well region 172 through the third well region 173 to the fourth well region 174, and the forward ESD voltage applied through the first electrode E1 may be discharged to the second electrode E2 through the third diffusion region 183 and the second connection wiring 320.

In addition, when the forward ESD voltage is applied through the first electrode E1, the potential of the first well region 171 rises together since the first diffusion region 181 and the fourth diffusion region 184 are electrically connected through the first connection wiring 310. Accordingly, the first well region 171 and the first doping region 131 may be in a reverse bias state, thereby forming a depletion region. That is, the first diode DE1 may be turned off and the second transistor Q2 may not be turned on.

When the forward ESD voltage is applied through the first electrode E1, the potential of the third well region 173 may become higher than the potential of the fourth well region 174. Accordingly, the fourth well region 174 and the third well region 173 may be in a reverse bias state, thereby forming a depletion region. That is, the second diode DE2 may be turned off and the third transistor Q3 may not be turned on.

When the reverse ESD voltage is applied through the first electrode E1, the potential of the first diffusion region 181 and the second well region 172 decreases. Accordingly, the first transistor Q1 including the first diffusion region 181, the second well region 172, the third well region 173, the first drift region 141, the fourth well region 174, and the third diffusion region 183 may be turned on in the reverse direction. In this case, the reverse ESD voltage less than or equal to a predetermined value is required for the first transistor Q1 to be turned on in the reverse direction. That is, the first transistor Q1 may be turned on when the reverse ESD voltage is less than the first reverse trigger voltage of the first transistor Q1. As used herein, the first reverse trigger voltage may refer to as a voltage for the first transistor Q1 to be turned on in the reverse direction. The first reverse trigger voltage of the first transistor Q1 may have a predetermined value. The size of the first reverse trigger voltage may be substantially similar and/or equal to the size of the first forward trigger voltage. For example, the first reverse trigger voltage of the first transistor Q1 may be, but is not limited to, -12 V to -50 V.

In this case, current may flow from the second well region 172 through the third well region 173 to the fourth well region 174, and the reverse ESD voltage applied through the first electrode E1 may be discharged to the second electrode E2 through the third diffusion region 183 and the second connection wiring 320.

In addition, when the reverse ESD voltage is applied through the first electrode E1, the potential of the first well region 171 decreases together since the first diffusion region 181 and the fourth diffusion region 184 are electrically connected through the first connection wiring 310. Accordingly, the potential of the first well region 171 may become higher than the potential of the first doping region 131, and the first diode DE1 may be turned on. Accordingly, the potential of the first doping region 131 may be reduced.

The doping concentration of the first epitaxial layer 121 forming the base of the second transistor Q2 and/or the doping concentration of the first drift region 141 may be less than the doping concentration of the third well region 173 forming the base of the first transistor Q1. Accordingly, the punch-through phenomenon may occur within the first epitaxial layer 121 and/or the first drift region 141.

That is, as the potential of the first doping region 131 decreases, a reverse bias state may be formed between the first doping region 131 having the first conductivity type and the first epitaxial layer 121 having the second conductivity type, and/or between the first doping region 131 and the first drift region 141 having the second conductivity type, thereby forming a depletion region. In this case, as the first epitaxial layer 121 and/or the first drift region 141 are doped with low concentration, the depletion region may be formed up to the second doping region 132. Accordingly, the punch-through phenomenon in which current flows from the first doping region 131 to the second doping region 132 may occur, regardless of the potential of the base of the second transistor Q2.

Additionally, in an embodiment, the doping concentration of the first epitaxial layer 121 may be less than the doping concentration of the first drift region 141. Accordingly, within a range where the first width W1 of the first epitaxial layer 121 in the first direction (X direction) is less than or equal to the second width W2 of the first drift region 141 in the first direction (X direction), the punch-through phenomenon in which current flows from the first doping region 131 to the second doping region 132 through the first epitaxial layer 121 may occur more readily.

Additionally, in an embodiment, the second reverse trigger voltage of the second transistor Q2 may depend on the first width W1 of the first epitaxial layer 121 in the first direction (X direction) and the second width W2 of the first drift region 141 in the first direction (X direction). For example, as the first width W1 of the first epitaxial layer 121 in the first direction (X direction) and the second width W2 of the first drift region 141 in the first direction (X direction) decrease, the size of the second reverse trigger voltage may decrease, and as the first width W1 of the first epitaxial layer 121 in the first direction (X direction) and the second width W2 of the first drift region 141 in the first direction (X direction) increase, the size of the second reverse trigger voltage may increase. That is, the lesser the width of the first epitaxial layer 121 and the first drift region 141, the more readily the punch-through phenomenon may occur.

In summary, as the first epitaxial layer 121 and/or the first drift region 141 is doped with low concentration, the size of the reverse ESD voltage for turning the second transistor Q2 on in the reverse direction may be reduced. Therefore, when the reverse ESD voltage is applied to the first electrode E1, the second transistor Q2 may be turned on before the first transistor Q1 is turned on. The size of the second reverse trigger voltage for turning the second transistor Q2 on in the reverse direction may be less than the size of the first reverse trigger voltage for turning the first transistor Q1 on in the reverse direction. That is, the electrostatic discharge protection device 100 according to an embodiment may turn on the second transistor Q2 even when the reverse ESD voltage having a size less than the size of the first reverse trigger voltage of the first transistor Q1 is applied to the first electrode E1. For example, the second reverse trigger voltage may be, but is not limited to, -2.8 V to -8 V.

Additionally, when the reverse ESD voltage is applied through the first electrode E1, the potential of the first drift region 141 may decrease. Accordingly, the second diode DE2 including the first drift region 141 and the fourth well region 174 may be turned on. Additionally, when the reverse ESD voltage is applied through the first electrode E1, the third transistor Q3 may be turned on as the potential of the first well region 171 decreases. Accordingly, current may be discharged from the first electrode E1 to the second electrode E2 through the fourth diffusion region 184, the first well region 171, the second well region 172, the third well region 173, the first drift region 141, the fourth well region 174, and the third diffusion region 183.

At this time, a third reverse trigger voltage of the third transistor Q3 may depend on a first distance D1 between the first well region 171 and the second well region 172. For example, as the first distance D1 between the first well region 171 and the second well region 172 decreases, the size of the third reverse trigger voltage may increase, and as the first distance D1 between the first well region 171 and the second well region 172 increases, the size of the third reverse trigger voltage may decrease. Consequently, the first doping region 131 that is doped with a relatively low concentration may be disposed between the first well region 171 and the second well region 172.

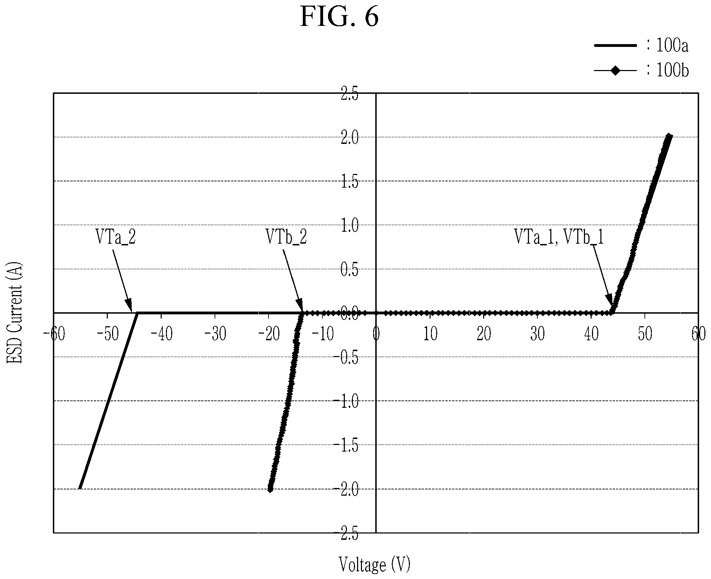

An electrostatic discharge protection device, according to an embodiment, is described with further reference to FIG. 6.

FIG. 6 is a graph showing a voltage-current curve of the electrostatic discharge protection device, according to an embodiment.

FIG. 6 is a graph showing the trigger voltage of an electrostatic discharge protection device 100b, according to an embodiment, and the trigger voltage of an electrostatic discharge protection device 100a, according to a comparative example. The comparative example shows the electrostatic discharge protection device 100a that does not include the first well region 171 and the fourth diffusion region 184, and the electrostatic discharge protection device 100b, according to an embodiment, includes the first well region 171 and the fourth diffusion region 184 of FIGS. 1 to 5. That is, the electrostatic discharge protection device 100a according to the comparative example may mean a case in which the first transistor Q1 of the embodiments of FIGS. 1 to 5 is included, and the second transistor Q2 and the third transistor Q3 are not included.

Referring further to FIG. 6, the first forward trigger voltage of the electrostatic discharge protection device 100b according to the comparative example may be VTa_1, and the first reverse trigger voltage may be VTa_2. According to an embodiment, the second forward trigger voltage of the electrostatic discharge protection device 100a may be VTb_1, and the second reverse trigger voltage may be VTb_2. In an embodiment, a first forward trigger voltage VTa_1 of the electrostatic discharge protection device 100b, according to the comparative example, may be substantially similar and/or equal to the first forward trigger voltage of the first transistor Q1 of the embodiments of FIGS. 1 to 5. A first reverse trigger voltage VTa_2 of the electrostatic discharge protection device 100b, according to the comparative example, may be substantially similar and/or the same as the first reverse trigger voltage of the first transistor Q1 of the embodiments of FIGS. 1 to 5.

As shown in the graph, it may be seen that the electrostatic discharge protection device 100a may operate at the first reverse trigger voltage VTa_2 having a relatively large size when the second transistor Q2 and the third transistor Q3 are not included. Therefore, the electrostatic discharge protection device 100a that does not include the second transistor Q2 and the third transistor Q3 may be insufficient to protect an integrated circuit device (e.g., integrated circuit device 500 in FIG. 1) from a reverse ESD voltage having a small size.

Alternatively, the electrostatic discharge protection device 100b including the second transistor Q2 and the third transistor Q3 may operate at the second reverse trigger voltage VTb_2 having a relatively small size because the electrostatic discharge protection device 100b utilizes the punch-through phenomenon within the first epitaxial layer 121 and/or the first drift region 141. Accordingly, the electrostatic discharge protection device 100b according to an embodiment may protect the integrated circuit device (e.g., integrated circuit device 500 in FIG. 1) from a reverse ESD voltage having a size smaller than that of the first reverse trigger voltage VTa_2.

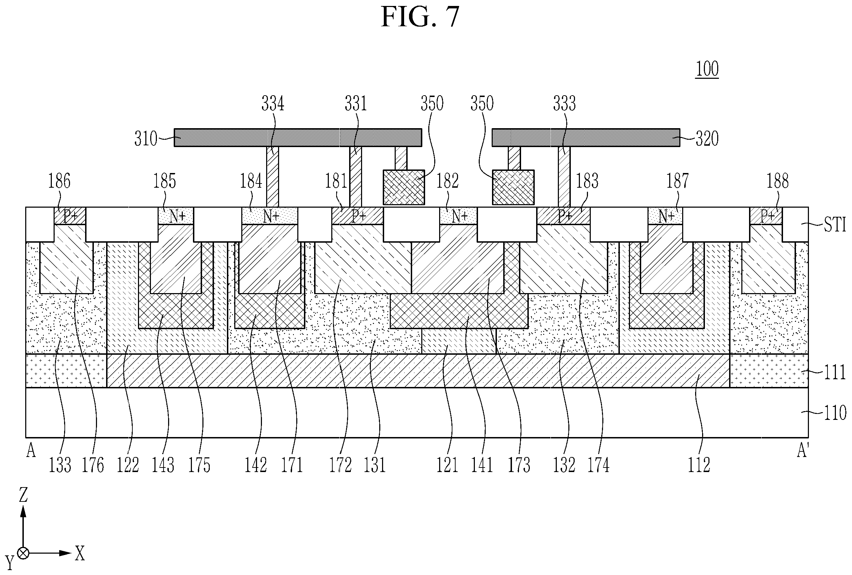

Hereinafter, electrostatic discharge protection devices, according to some embodiments, are described with reference to FIGS. 7 to 13.

FIGS. 7 to 13 are cross-sectional views corresponding to line A-A' of FIG. 2, illustrating the electrostatic discharge protection devices, according to some embodiments.

FIGS. 7 to 13 illustrate various modified examples of the electrostatic discharge protection devices, according to an embodiment illustrated in FIGS. 1 to 6. The embodiments illustrated in FIGS. 7 to 13 may be substantially similar in many respects to the embodiments illustrated in FIGS. 1 to 6, so a description thereof may be omitted for the sake of brevity and the differences are briefly described. Additionally, the same drawing numerals are used for the same components as in the previous embodiment.

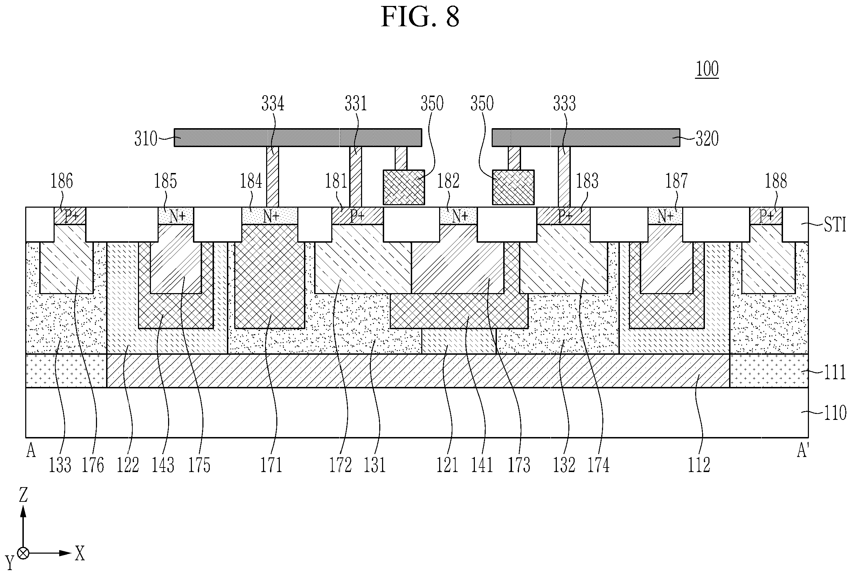

Referring to FIGS. 7 and 8, the electrostatic discharge protection device 100, according to some embodiments, may further include a second drift region 142 disposed between the first doping region 131 and the first well region 171.

The second drift region 142 may be disposed on the first doping region 131. The second drift region 142 may be surrounded by the second doping region 132. The second drift region 142 may surround the first well region 171. The second drift region 142 may be spaced apart from the second well region 172 in the first direction (X direction), however, the present disclosure is not limited thereto. The second drift region 142 may be formed at a substantially similar and/or the same depth as the first drift region 141. The lower surface of the second drift region 142 may be disposed at the same level as the lower surface of the first drift region 141. That is, the lower surface of the second drift region 142 may be disposed at a substantially similar and/or the same distance from the lower surface of the first drift region 141 and the upper surface of the substrate 110.

The second drift region 142 may have the same conductivity type as the first well region 171 and the first epitaxial layer 121. For example, the second drift region 142 may be doped with the second conductive impurity to have the second conductivity type. The second conductivity type may be an n-type. The doping concentration of the second drift region 142 may be greater than the doping concentration of the first epitaxial layer 121 and may be less than the doping concentration of the first well region 171.

The electrostatic discharge protection device 100, according to some embodiments, may not include the first well region 171. For example, as shown in FIG. 8, the electrostatic discharge protection device 100, according to some embodiments, may include the second drift region 142 on the first doping region 131, and the fourth diffusion region 184 may be disposed directly on the upper surface of the second drift region 142. That is, the lower surface of the fourth diffusion region 184 may be in contact with the upper surface of the second drift region 142. Even in the case of the embodiment of FIG. 8, a PN junction may be formed at the junction interface between the second drift region 142 having the second conductivity type and the first doping region 131 having the first conductivity type. The second drift region 142 and the first doping region 131 may form the first diode (e.g., first diode DE1 in FIG. 5).

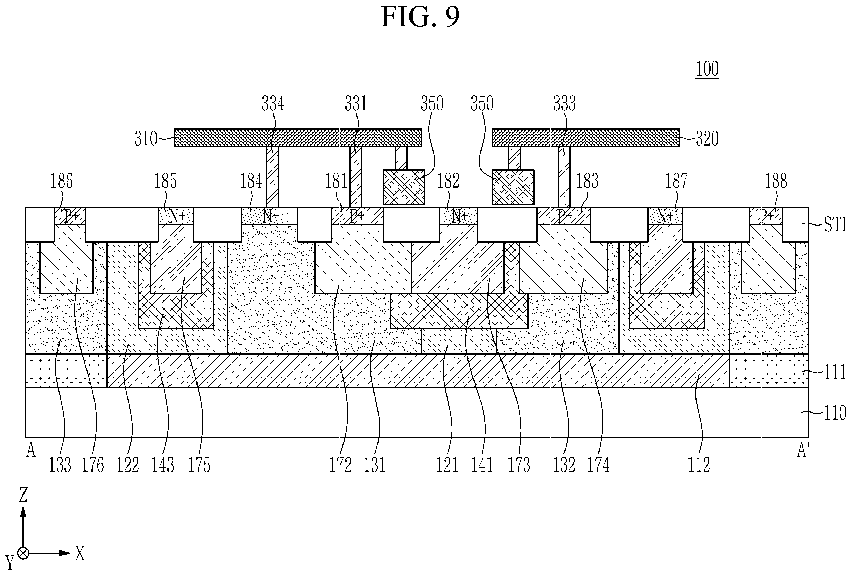

Referring to FIG. 9, the electrostatic discharge protection device 100 according to some embodiments may not include the first well region 171. For example, the fourth diffusion region 184 of the electrostatic discharge protection device 100 according to some embodiments may be disposed directly on the upper surface of the first doping region 131. The lower surface of the fourth diffusion region 184 may be in contact with the upper surface of the first doping region 131.

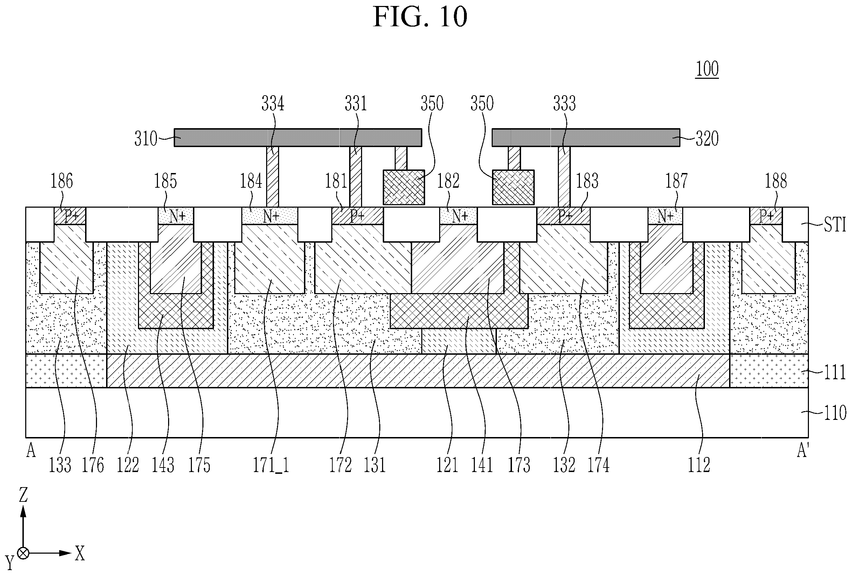

Referring to FIG. 10, a first well region 171_1 of the electrostatic discharge protection device 100, according to some embodiments, may have a different conductivity type from the fourth diffusion region 184. For example, the first well region 171_1 may have the same conductivity type as the second well region 172 and/or the first doping region 131. The first well region 171_1 may be doped with the first conductivity type impurity to have the first conductivity type. The first conductivity type may be a p-type. In this case, the doping concentration of the first well region 171_1 may be greater than the doping concentration of the first doping region 131. The first well region 171_1 and the second well region 172 may be spaced apart from each other, but are not limited thereto. The remaining description of the first well region 171_1 may be substantially similar in many respects as the description of the first well region 171 of FIGS. 1 to 6, and therefore a repeated description may be omitted for the sake of brevity.

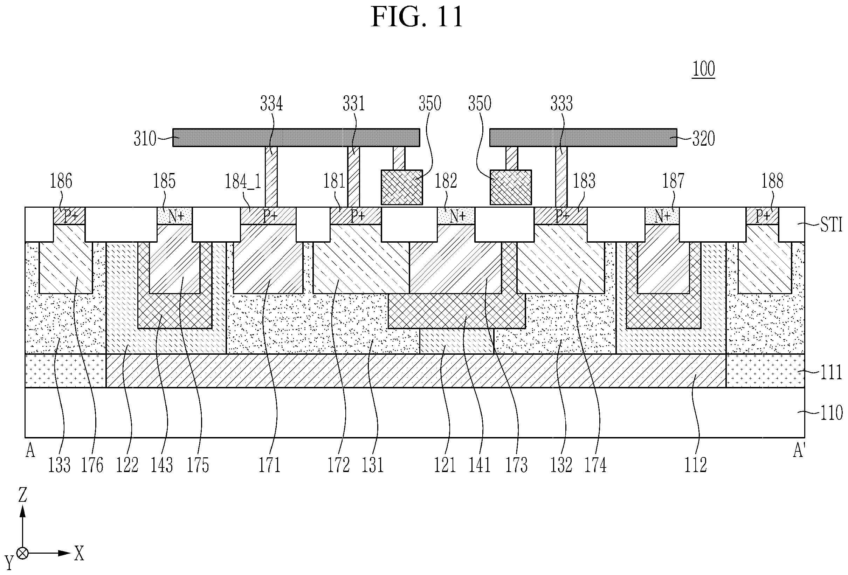

Referring to FIG. 11, a fourth diffusion region 184_1 of the electrostatic discharge protection device 100 according to some embodiments may have the same conductivity type as the first doping region 131. That is, the fourth diffusion region 184_1 may have a different conductivity type from the first well region 171. For example, the fourth diffusion region 184_1 may be doped with the first conductivity type impurity to have the first conductivity type. The first conductivity type may be a p-type. In this case, the doping concentration of the fourth diffusion region 184_1 may be greater than the doping concentration of the first doping region 131. The remaining description of the fourth diffusion region 184_1 may be substantially similar in many respects as the description of the fourth diffusion region 184 of FIGS. 1 to 6, and therefore a repeated description may be omitted for the sake of brevity.

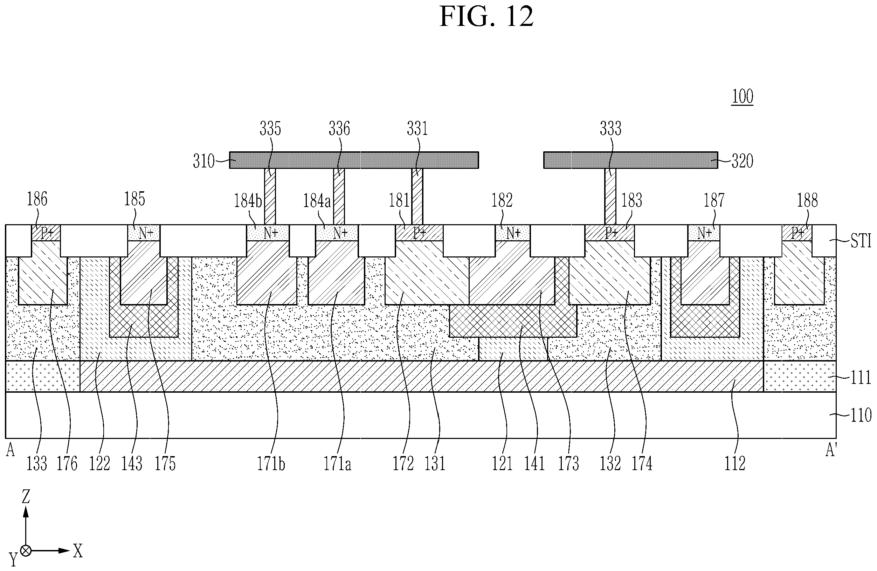

Referring to FIG. 12, the fourth diffusion region 184 of the electrostatic discharge protection device 100, according to some embodiments, may include a plurality of diffusion regions. For example, the fourth diffusion region 184 may include a first sub-diffusion region 184a and a second sub-diffusion region 184b spaced apart from each other in the first direction (X direction). The first sub-diffusion region 184a and the second sub-diffusion region 184b may be electrically connected to the first connection wiring 310. For example, the first sub-diffusion region 184a may be electrically connected to the first connection wiring 310 through a fifth via 336, and the second sub-diffusion region 184b may be electrically connected to the first connection wiring 310 through a sixth via 335. Accordingly, the first sub-diffusion region 184a and the second sub-diffusion region 184b may be electrically connected to the first diffusion region 181. Additionally, the first sub-diffusion region 184a may be electrically connected to the second sub-diffusion region 184b.

In some embodiments, the first sub-diffusion region 184a and the second sub-diffusion region 184b may have the same conductivity type as the second diffusion region 182. The first sub-diffusion region 184a and the second sub-diffusion region 184b may have different conductivity types from the first doping region 131. For example, the first sub-diffusion region 184a and the second sub-diffusion region 184b may be doped with the second conductive impurities to have the second conductivity type. The second conductivity type may be an n-type. In some embodiments, the first sub-diffusion region 184a and the second sub-diffusion region 184b may have the same conductivity types, however, the present disclosure is not limited thereto, and the first and second sub-diffusion regions 184a and 184b may have different conductivity types. The remaining description of each of the first sub-diffusion region 184a and the second sub-diffusion region 184b may be substantially similar in many respects as the description of the first diffusion region 181 of the embodiments of FIGS. 1 to 6, and therefore a repeated description may be omitted for the sake of brevity.

Additionally, a plurality of first well regions 171 of the electrostatic discharge protection device 100, according to some embodiments, may be provided. For example, the first well region 171 may include a first sub-well region 171a and a second sub-well region 171b that are spaced apart from each other in the first direction (X direction). The first sub-well region 171a may be disposed between the first sub-diffusion region 184a and the first doping region 131, and the second sub-well region 171b may be disposed between the second sub-diffusion region 184b and the first doping region 131. The first sub-well region 171a and the second sub-well region 171b may be spaced apart from each other in the first direction (X direction), however, the present disclosure is not limited thereto.

In some embodiments, the first sub-well region 171a may have the same conductivity type as the first sub-diffusion region 184a, and the second sub-well region 171b may have the same conductivity type as the second sub-diffusion region 184b. For example, the first sub-well region 171a and the second sub-well region 171b may be doped with the second conductive impurities to have the second conductivity types. The second conductivity type may be an n-type. The doping concentrations of the first sub-well region 171a and the second sub-well region 171b may be less than the doping concentrations of the first sub-diffusion region 184a and the second sub-diffusion region 184b, and may be less than the doping concentrations of the first drift region 141 and the first epitaxial layer 121.

In FIG. 12, a case where the fourth diffusion region 184 is formed of two (2) diffusion regions is shown, but the number of fourth diffusion regions 184 and the number of first well regions 171 are not limited thereto. For example, there may be three (3) or more fourth diffusion regions 184 and first well regions 171.

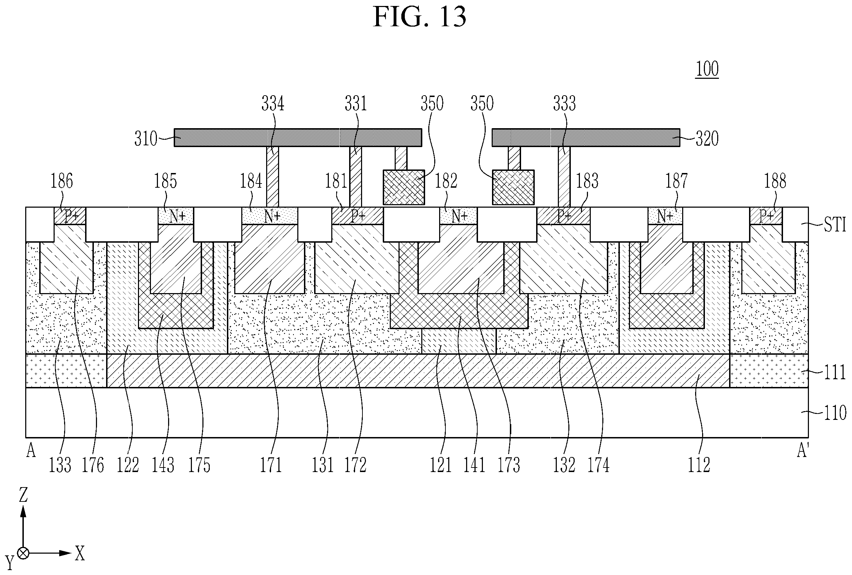

Referring to FIG. 13, the second well region 172 and the third well region 173 of the electrostatic discharge protection device 100 according to some embodiments may be spaced apart from each other. For example, the second well region 172 and the third well region 173 may be spaced apart from each other in the first direction (X direction). In this case, the first drift region 141 may be disposed between the second well region 172 and the third well region 173.

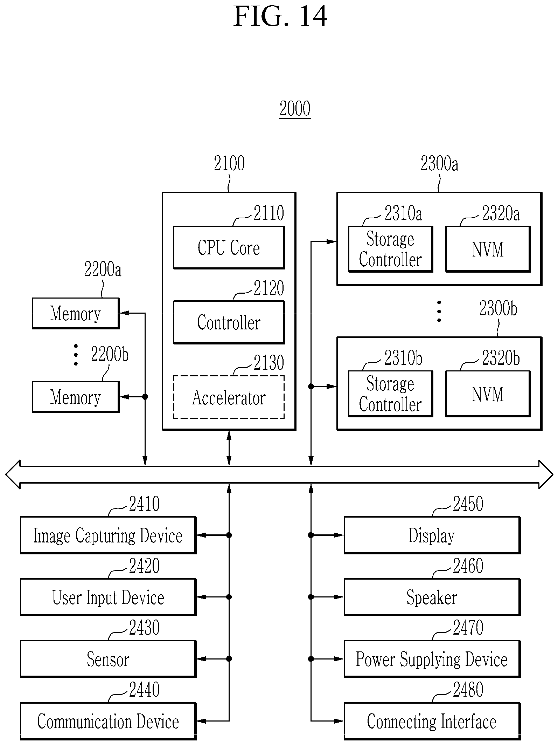

Hereinafter, a system including an electrostatic discharge protection device, according to an embodiment, is described with reference to FIG. 14.

FIG. 14 is a block diagram illustrating a system including an electrostatic discharge protection device, according to an embodiment.

Referring to FIG. 14, a system 2000 may include a main processor 2100, memories (e.g., a first memory 2200a and a second memory 2200b), and storage devices (e.g., a first storage device 2300a and a second storage device 2300b), and may further include one or more of an image capturing device 2410, a user input device 2420, a sensor 2430, a communication device 2440, a display 2450, a speaker 2460, a power supply device 2470, and a connection interface 2480.

The main processor 2100 may control overall operation of the system 2000, such as, but not limited to, operations of other components included in the system 2000. The main processor 2100 may be implemented as a universal processor, a dedicated processor, or an application processor.

The main processor 2100 may include one or more CPU cores 2110, and may further include a controller 2120 for controlling the first and second memories 2200a and 2200b and/or the first and second storage devices 2300a and 2300b. Depending on embodiments, the main processor 2100 may further include an accelerator 2130, which may be a dedicated circuit for a high-speed data operation, such as artificial intelligence (AI) data operation. The accelerator 2130 may include a graphics processing unit (GPU), a neural processing unit (NPU), and/or a data processing unit (DPU), and may be implemented as a chip physically separate from the other components of the main processor 2100.

The first and second memories 2200a and 2200b may be used as main memory devices of the system 2000, and although the first and second memories 2200a and 2200b may include a volatile memory, such as static random-access memory (SRAM) and/or dynamic random-access memory (DRAM), the first and second memories 2200a and 2200b may also include a non-volatile memory, such as, but not limited to, a flash memory, a phase-change random-access memory (PRAM), a resistive random-access memory (RRAM), or the like. The first and second memories 2200a and 2200b may also be implemented in the same package as the main processor 2100.

The first and second storage devices 2300a and 2300b may function as non-volatile storage devices that may store data regardless of whether power is supplied thereto, and may have a relatively large storage capacity when compared to the first and second memories 2200a and 2200b. The storage devices 2300a and 2300b may include storage controllers (e.g., a first storage controller 2310a and a second storage controller 2310b) and non-volatile memories (NVMs) (e.g., a first NVM 2320a and a second NVM 2320b) that stores data under the control of the first and second storage controllers 2310a and 2310b. The first and second non-volatile memories 2320a and 2320b may include a 2-dimensional (2D) structure and/or a 3-dimensional (3D) V-NAND (Vertical NAND) flash memory, and/or may include other types of non-volatile memory such as a PRAM and/or a RRAM.

The first and second storage devices 2300a and 2300b included in the system 2000 may be physically separated from the main processor 2100 and/or may be implemented in the same package within the main processor 2100. In addition, the first and second storage devices 2300a and 2300b may take the form of solid-state devices (SSDs) or memory cards and may be removably combined with other components of the system 2000 through an interface, such as a connection interface 2480. The first and second storage devices 2300a and 2300b may be devices to which a standard protocol, such as a universal flash storage (UFS), an embedded multi-media card (eMMC), or a non-volatile memory express (NVMe), may be applied, however, the present disclosure is not limited thereto, and the first and second storage devices 2300a and 2300b may be implemented using other protocols.

The image capturing device 2410 may capture still images and/or moving images, and may include, but not be limited to, a camera, a camcorder, and/or a webcam.

The user input device 2420 may receive various types of data input from a user of the system 2000, and may include, but not be limited to, a touch pad, a keypad, a keyboard, a mouse, and/or a microphone.

The sensor 2430 may detect various types of physical quantities, which may be obtained from outside the system 2000, and may convert the detected physical quantities into electrical signals. The sensor 2430 may include, but not be limited to, a temperature sensor, a pressure sensor, a light sensor, a position sensor, an acceleration sensor, a biosensor, and/or a gyroscope sensor.

The communication device 2440 may transmit and/or receive signals between other devices outside the system 2000, according to various communication protocols. The communication device 2440 may be implemented including an antenna, a transceiver, and/or a modem.

The display 2450 and the speaker 2460 may function as output devices that may output visual information and/or auditory information, respectively, to the user of the system 2000.

The power supply device 2470 may appropriately convert power supplied from a battery built into the system 2000 and/or from an external power source and supply the power to each component of the system 2000. For example, the power supply device 2470 may include one or more power management integrated circuits (PMIC). The power supply device 2470 may include an ESD protection device as described with reference to FIGS. 1 to 13.

The connection interface 2480 may provide a connection between the system 2000 and an external device, which may be connected to the system 2000 and may be capable of transmitting and/or receiving data to and/or from the system 2000. The connection interface 2480 may be implemented by using various interface schemes, such as, but not limited to, advanced technology attachment (ATA), serial ATA (SATA), external SATA (e-SATA), small computer small interface (SCSI), serial attached SCSI (SAS), peripheral component interconnection (PCI), PCI express (PCIe), NVMe, IEEE 1394 (FireWire), universal serial bus (USB), secure digital (SD) card, multi-media card (MMC), eMMC, UFS, embedded Universal Flash Storage (eUFS), and compact flash (CF) card interface.

While this disclosure has been described in connection with what is presently considered to be practical embodiments, it is to be understood that the disclosure is not limited to the disclosed embodiments, but, on the contrary, is intended to cover various modifications and equivalent arrangements included within the scope of the appended claims.

## Claims

1. An electrostatic discharge protection device, comprising:
a substrate (110);
a first doping region (131) of a first conductivity type on the substrate (110);
a second doping region (132) of the first conductivity type on the substrate (110);
an epitaxial layer (121) of a second conductivity type between the first doping region (131) and the second doping region (132);
a first diffusion region (181) of the first conductivity type on the first doping region (131);
a second diffusion region (182) of the second conductivity type on the epitaxial layer (121);
a third diffusion region (183) of the first conductivity type on the second doping region (132); and
a fourth diffusion region (184; 184_1) of the second conductivity type on the first doping region (131) and spaced apart from the first diffusion region (181),
wherein the first diffusion region (181) and the fourth diffusion region are electrically coupled.

2. The electrostatic discharge protection device of claim 1, wherein the first conductivity type is a p-type, and
wherein the second conductivity type is an n-type.

3. The electrostatic discharge protection device of claim 1 or 2, further comprising:
a first well region (171) between the fourth diffusion region (184; 184_1) and the first doping region (131),
wherein a first doping concentration of the first well region (171) is greater than a second doping concentration of the epitaxial layer (121).

4. The electrostatic discharge protection device of claim 3, further comprising:
a first drift region (141) of the second conductivity type between the epitaxial layer (121) and the second diffusion region (182),
wherein a third doping concentration of the first drift region (141) is less than the first doping concentration of the first well region (171).

5. The electrostatic discharge protection device of claim 4, wherein a first width (W1) of the epitaxial layer (121) is smaller than or equal to a second width (W2) of the first drift region (141).

6. The electrostatic discharge protection device of any one of claims 3 to 5, further comprising:
a second well region (172) of the first conductivity type between the first doping region (131) and the first diffusion region (181); and
a third well region (173) of the second conductivity type between the epitaxial layer (121) and the second diffusion region (182),
wherein a third doping concentration of the third well region (173) is greater than the second doping concentration of the epitaxial layer.

7. The electrostatic discharge protection device of claim 6, wherein a first side surface of the second well region (172) is in contact with a second side surface of the third well region (173).

8. The electrostatic discharge protection device of claim 6 or 7, wherein a fourth doping concentration of the first doping region (131) is less than a fifth doping concentration of the second well region (172).

9. The electrostatic discharge protection device of claim 6 to 8, wherein the second well region (172) is spaced apart from the first well region (171).

10. The electrostatic discharge protection device of any one of claims 6 to 9, further comprising:
a first drift region (141) of the second conductivity type between the epitaxial layer (121) and the third well region (173),
wherein a fourth doping concentration of the first drift region (141) is less than the third doping concentration of the third well region (173).

11. The electrostatic discharge protection device of claim 10, wherein the fourth doping concentration of the first drift region (141) is less than the second doping concentration of the epitaxial layer (121).

12. The electrostatic discharge protection device of claim 10 or 11, wherein the first drift region (141) at least partially overlaps the second well region (172) in a thickness direction of the substrate (110).

13. The electrostatic discharge protection device of claim 1 or 2, further comprising:
a second drift region (142) of the second conductivity type between the first doping region (131) and the fourth diffusion region (184; 184_1),
wherein a first doping concentration of the second drift region (142) is greater than a second doping concentration of the epitaxial layer (121).

14. The electrostatic discharge protection device of claim 13, further comprising:
a first well region (171) in the second drift region (142) and in contact with the fourth diffusion region (184; 184_1),
wherein the first doping concentration of the second drift region (142) is less than a third doping concentration of the first well region (171).

15. The electrostatic discharge protection device of any one of claims 1 to 14, wherein a third width (W3) of the fourth diffusion region (184) is greater than or equal to a fourth width (W4) of the first diffusion region (181).
